# EUROPEAN PATENT SPECIFICATION

(11) **EP 2 105 744 B1**
(45) Date of publication and mention of the grant of the patent: **07.10.2015**
(21) Application number: 07831715.3
(22) Date of filing: 13.11.2007
(51) Int. Cl.: G01N 35/08, G01N 37/00, B01J 19/00, B01L 3/00

(54) **MICROCHIP AND PROCESS FOR PRODUCING MICROCHIP**
MIKROCHIP UND VERFAHREN ZUR HERSTELLUNG DES MIKROCHIPS
MICROPUCE ET SON PROCÉDÉ DE FABRICATION

(30) Priority: 16.01.2007 JP 2007006753
(43) Date of publication of application: 30.09.2009
(73) Proprietor: Konica Minolta Opto, Inc., Hachioji-shi, Tokyo 192-8505 (JP)
(72) Inventor: HIRAYAMA, Hiroshi, Hachioji-shi Tokyo 192-8505 (JP)
(74) Representative: Henkel, Breuer & Partner
(86) International application number: PCT/JP2007/071985
(87) International publication number: WO 2008/087787

(56) References cited:
- EP-A1- 1 362 827
- JP-A- 2002 174 610
- JP-A- 2005 114 414
- US-A1- 2002 072 103
- US-A1- 2003 150 555

## Description

### TECHNICAL FIELD

The present invention relates to a microchip in which flow path grooves are formed, and a method of manufacturing a microchip thereof.

### BACKGROUND

Practically utilized has been an apparatus called a microanalysis chip or a µTAS (Micro Total Analysis System) by which fine flow paths and circuits are formed on a silicon or glass substrate employing a fine processing technology, and chemical reaction, separation and analysis of a liquid specimen such as a nucleic acid, a protein, blood or the like are conducted in fine space. As the advantage of such the microchip, it is considered that a consumption amount of a specimen and a reagent, or a discharging amount of waste is reduced, and a space-saving, portable system is realized at low cost.

The microchip is prepared by attaching two members together in which at least one member is subjected to fine processing. In the past, a glass substrate has been utilized, and various fine processing methods have also been proposed. However, since glass substrates are not suitable for mass-production, and are very expensive, an inexpensive, disposable microchip made of a resin is desired to be developed.

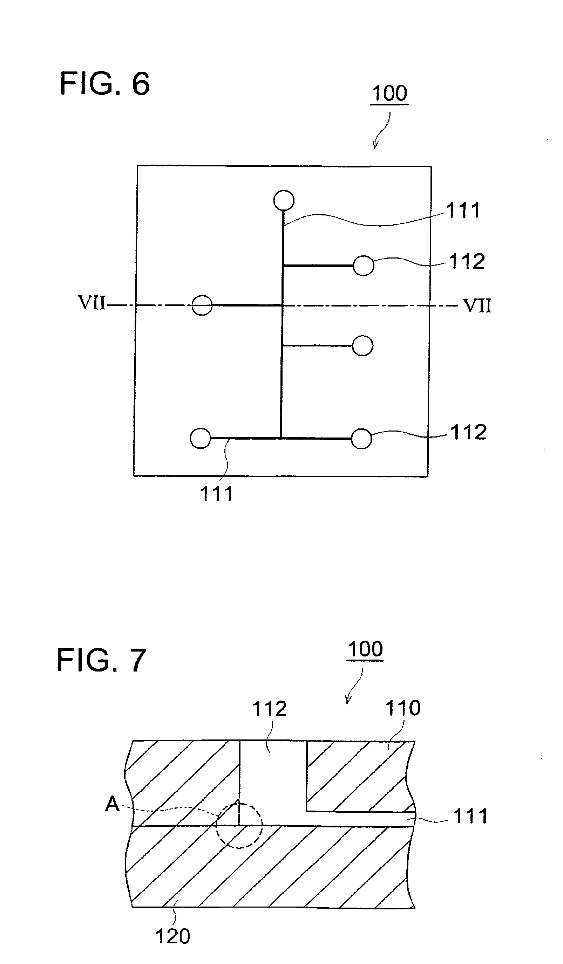

Herein, the configuration of a microchip relating to the prior art will be described referring to Fig. 6 and Fig. 7. Fig. 6 is a top view showing a microchip in the prior art. Fig. 7 is a cross-sectional view showing the microchip in the prior art, and is a VII-VII cross-sectional view. Microchip 100 possesses microchip substrate 110 in which fine flow path 111 is formed on the surface, and microchip substrate 120 in the form of a flat plate to cover fine flow path 111. Microchip 100 is prepared by attaching microchip substrates 110 and 120 so as to place fine flow path 111 on the inward side. Further, opening 112 is formed in microchip 100 in order to introduce a reagent in the form of gel or liquid into fine flow path 111, and to discharge it from fine flow path 111. In examples shown in Fig. 6 and Fig. 7, a through-hole is formed in microchip substrate 110 on which fine flow path 111 is formed, and microchips 110 and 120 are attached to each other to form opening 112. A reagent or the like is introduced from this opening 112 into fine flow path 111, or the reagent or the like in fine flow path 111 is discharged from opening 112.

Further, examples of the attachment method of a microchip substrate include an attachment method with an adhesive; an attachment method by which the surface of a resin substrate is dissolved with an organic solvent (Patent Document 1, for example); an attachment method using ultrasonic fusion (Patent Document 2, for example); an attachment method using thermal fusion (Patent Document 3, for example); and an attachment method using laser fusion (Patent Document 4, for example).
Patent Document 1: Japanese Patent O.P.I. Publication No. 2005-80569
Patent Document 2: Japanese Patent O.P.I. Publication No. 2005-77239
Patent Document 3: Japanese Patent O.P.I. Publication No. 2005-77218
Patent Document 4: Japanese Patent O.P.I. Publication No. 2005-74796

US 2002/0072103 A1 discloses a microchip made of two substrates with a dielectric film formed separately on the upper and lower substrate.

Furthermore a method for fabricating a micro fluid device is disclosed in EP 1 362 827 A1. According to this document two glas substrates are attached together, wherein a film is formed on one of the substrates, before the second substrate is attached thereto.

### DISCLOSURE OF THE INVENTION

### PROBLEMS TO BE SOLVED BY THE INVENTION

However, in cases where a substrate made of a resin is attached to another substrate made of a resin by the above-described method, molding strain is increased around an opening portion formed in a microchip, whereby the surface accuracy is deteriorated. Because of this, when strongly attaching a microchip substrate to another microchip substrate around the opening portion, a fine flow path tends to be damaged. Further, when attaching a microchip substrate to another microchip substrate so as not to damage the fine flow path, fine spacing is produced between a microchip substrate in which a through-hole is formed, and another microchip substrate in which no through-hole is formed, whereby a reagent or the like tends to leak during pressure-feeding or electrophoresis of the reagent in the form of liquid. For example, as shown in Fig. 7, in the vicinity of opening portion 112 (portion A indicated by a dashed circle), spacing is generated between microchip substrate 110 and microchip substrate 120, whereby the reagent or the like tends to leak from the spacing. An adhesive or a seal material is considered to be utilized in order to prevent leakage of the reagent or the like, but since the fine flow path has a width of several tens of micrometers, it is difficult to provide the adhesive or the seal material at desired portions, whereby the fine flow path tends to be sealed with the adhesive or the like.

The present invention has been made on the basis of the above-described problem to be solved, and it is an object of the present invention to provide a microchip capable of preventing leakage of the reagent or the like by filling in the spacing between substrates in the vicinity of the opening portion formed in the microchip, and also to provide a method of manufacturing the microchip.

According to the present invention the above object is achieved by a microchip according to claim 1 and by a method for manufacturing a microchip according to claim 9. The dependent claims are directed to further advantageous aspects of the invention.

### MEANS TO SOLVE THE PROBLEMS

(Structure 1) A microchip comprising a flow path groove formed on a surface of at least one of two substrates each made of a resin, and a through-hole communicated with the flow path groove to form an opening portion to the outside in at least one of the two substrates each made of a resin, wherein the two substrates are attached to each other so as to place the surface on which the flow path groove is formed on an inward side, and wherein at least one dielectric film is formed on an inner surface of the opening portion.

(Structure 2) The microchip of Structure 1, wherein the dielectric film is an SiO₂ film or a TiO₂ film.

(Structure 3) The microchip of Structure 1, wherein the dielectric film comprises layered films each made of a different material.

(Structure 4) The microchip of Structure 3, wherein the dielectric film comprises a TiO₂ film, and a SiO₂ film layered on the TiO₂ film.

(Structure 5) The microchip of any one of Structures 1 - 4, wherein a ratio (t₁/t₂) of thickness t₁ of a dielectric film formed on an inward side surface of the opening portion to thickness t₂ of another dielectric film formed on a bottom surface of the opening portion, via attachment of the two substrates to each other, is at least 1/10.

(Structure 6) The microchip of any one of Structures 1 - 4, wherein a ratio (t₁/t₂) of thickness t₁ of a dielectric film formed on an inward side surface of the opening portion to thickness t₂ of another dielectric film formed on a bottom surface of the opening portion, via attachment of the two substrates to each other, is at least 1/3.

(Structure 7) The microchip of any one of Structures 1 - 4, wherein a ratio (t₁/t₂) of thickness t₁ of a dielectric film formed on an inward side surface of the opening portion to thickness t₂ of another dielectric film formed on a bottom surface of the opening portion, via attachment of the two substrates to each other, is at least 1/2.

(Structure 8) The microchip of any one of Structures 1 - 7, comprising the dielectric film formed on the inner surface of the opening portion and on another surface of the flow path groove.

(Structure 9) The microchip of any one of Structures 1 - 8, comprising the dielectric film not only formed on the surface of the substrate made of a resin, in which the through-hole is formed, but also formed on a surface of an opposite side of a surface attached onto another substrate made of a resin.

(Structure 10) The microchip of any one of Structures 1 - 9, comprising the dielectric film not only formed on the surface of the substrate made of a resin, in which the through-hole is not formed, but also formed on the surface of the opposite side of the surface attached onto another substrate made of a resin.

(Structure 11) The microchip of any one of Structures 1 - 10, comprising the dielectric film formed continuously from the inward side surface of the opening portion to the bottom surface of the opening portion formed via the attachment.

(Structure 12) A method of manufacturing a microchip comprising the steps of forming a flow path groove on a surface of at least one of two substrates each made of a resin; forming a through-hole communicated with the flow path groove in at least one of the two substrates each made of a resin to form an opening portion into the outside; and attaching the two substrates each made of a resin to each other so as to place the surface on which the flow path groove is formed on an inward side, wherein at least one dielectric film is formed on an inner surface of the opening portion.

(Structure 13) The method of Structure 12, further comprising the step of forming the dielectric film on the inner surface of the opening portion, after attaching the two substrates each made of a resin to each other.

(Structure 14) The method of Structure 12 or 13, further comprising the step of forming the dielectric film in the opening portion via plasma CVD, sputtering, coating or microplasma jet.

### EFFECT OF THE INVENTION

In accordance with the present invention, the spacing between substrates in the vicinity of the opening portion can be filled in by forming at least one dielectric film on the inner surface of the opening portion, whereby it becomes possible to prevent leakage of the reagent or the like in the vicinity of the opening portion.

### BRIEF DESCRIPTION OF THE DRAWINGS

Fig. 1 is a cross-sectional view of a microchip in the 1^{st} embodiment of the present invention.
Fig. 2 is a cross-sectional view of a microchip in the 2^{nd} embodiment of the present invention.
Fig. 3 is a cross-sectional view of a microchip in the 3^{rd} embodiment of the present invention.
Fig. 4 is a table showing the conditions of Examples in comparison to those of Comparative example.
Fig. 5 is a graph showing reflectance of a microchip in Example 6 of the present invention.
Fig. 6 is a top view showing a microchip in the prior art.
Fig. 7 is a cross-sectional view showing the microchip in the prior art, and is a VII-VII cross-sectional view.

### EXPLANATION OF NUMERALS

- 10, 14, 20, 22, 30, 35: Microchip substrate
- 11, 21, 31: Fine flow path
- 12, 23, 32: Opening portion
- 13, 24, 33, 34: Dielectric film

### DESCRIPTION OF THE PREFERRED EMBODIMENTS

### [The 1^{st} embodiment]

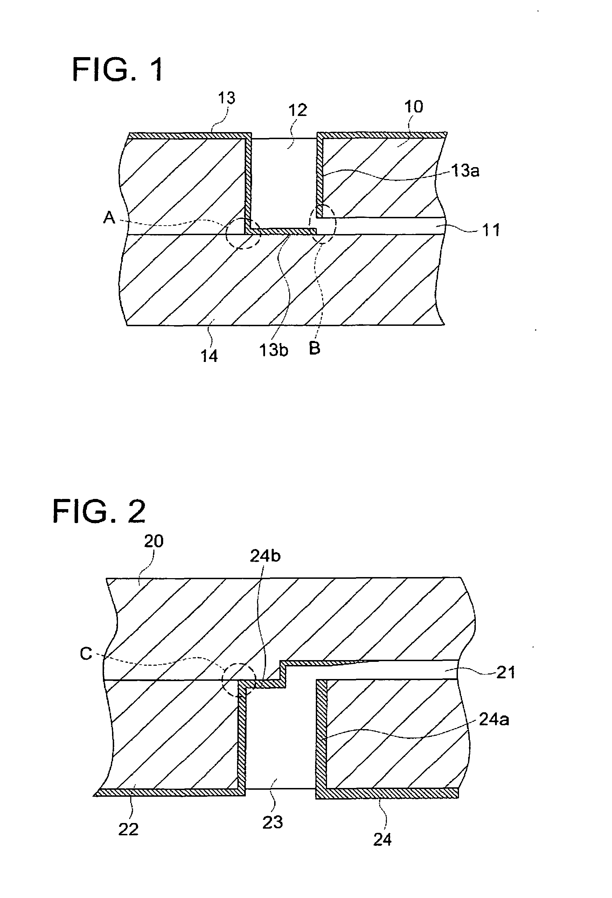

A microchip in the 1^{st} embodiment of the present invention, and a method of manufacturing the microchip will be described referring to Fig. 1. Fig. 1 is a cross-sectional view of a microchip in the 1^{st} embodiment of the present invention.

### (Configuration of microchip)

The microchip in the 1^{st} embodiment is fitted with microchip substrate 10 and microchip substrate 14. Fine flow path 11 in the form of a groove is formed on microchip substrate 10. Further, a through-hole passing through the substrate is formed in microchip substrate 10. This through-hole is formed so as to be brought into contact with fine flow path 11 to produce opening portion 12 by attaching microchip substrate 10 onto microchip substrate 14. Microchip substrate 14 as the other one to be attached onto microchip substrate 10 is a substrate in the form of a flat plate. Microchip substrate 10 and microchip substrate 14 are attached to each other so as to place the surface on which fine flow path 11 is formed on the inward side. By this, microchip substrate 14 serves as a lid of fine flow path 11 (a cover), and a through-hole formed in microchip substrate 10 becomes opening portion 12. In addition, each of microchip substrates 10 and 14 corresponds to an example for "a substrate made of a resin" of the present invention.

Since a through-hole in microchip substrate 10 is formed so as to be brought into contact with fine flow path 11, opening portion 12 produced by the through-hole is communicated with fine flow path 11. Opening portion 12 is a hole to introduce, store and discharge gel, a specimen or a buffer solution. Shape of opening portion 12 may be any shape other than circular shape and rectangular shape. A tube and a nozzle installed in an analyzer is connected to opening portion 12, and the gel, the specimen, the buffer solution or the like is introduced into fine flow path 11 via the tube and the nozzle, or is discharged from fine flow path 11.

Further, dielectric film 13 is formed on the inner surface of opening portion 12, and details thereof will be given. Dielectric film 13 is continuously formed with no rupture from the inward side surface of opening portion 12 to the bottom surface. Incidentally, in this specification, "inward side surface of opening portion 12" means the wall surface except the bottom surface in the opening portion, and in Fig. 1, means the wall surface perpendicular to the flow path direction of fine flow path 11. In addition, "inner surface of opening portion 12" means that "bottom surface of opening portion 12" is added into "inward side surface of opening portion 12". At the boundary between the inward side surface of opening portion 12 and the bottom surface of opening portion 12, dielectric film 13 is formed in a state where it is filled in. An SiO₂ film or a TiO₂ film is employed as this dielectric film 13. The SiO₂ film is a film made of SiO₂ as a principal component, and impurities other than SiO₂ may be contained, as long as the SiO₂ film maintains hydrophilic function. Further, The TiO₂ film is a film made of TiO₂ as a principal component, and impurities other than TiO₂ may be contained, as long as the TiO₂ film maintains hydrophilic function.

The film thickness of dielectric film 13 (SiO₂ film or TiO₂ film) is determined in consideration of the inner surface of opening portion 12 covered with dielectric film 13, acquisition of adhesiveness to the inner surface of opening portion 12, and no sealing of fine flow path 11 with an adhesive or the like. In cases where dielectric film 13 is formed via coating, the film thickness is adjusted depending on properties and kinds of the coating solution. For example, dielectric film 13 preferably has a thickness of 10 nm - 3 µm, and more preferably has a thickness of 10 nm - 2 µm. Further, in cases where dielectric film 13 is formed via sputtering and CVD, dielectric film 13 preferably has a thickness of 10 nm - 1 µm, and more preferably has a thickness of 50 - 500 nm since internal stress of the dielectric film tends to be increased.

Further, a ratio (t₁/t₂) of thickness t₁ of dielectric film 13a formed on the inward side surface of opening portion 12 to thickness t₂ of dielectric film 13b formed on the bottom surface of opening portion 12 is preferably at least 1/10. Further, the ratio (t₁/t₂) is more preferably at least 1/3, and still more preferably at least 1/2.

Generally, it is difficult to form a film evenly on a roughness product. In the case of an evaporation method by which a film forming material flies linearly to form the film, it is difficult to form an SiO₂ film on the inward side surface of opening portion 12. Accordingly, in cases where the film is filled in with no space at the boundary between the inward side surface of opening portion 12 and the bottom surface of opening portion 12, no efficiency is produced since it is necessary to form a film having a thickness 10 times thicker than that in a film formation method by which the film is evenly formed. Further, film quality of the inward side surface of opening portion 12 is largely different from that of the bottom surface of opening portion 12, resulting in a cause to block homogeneity of fine flow path 11, whereby this is not preferable. In a semiconductor process, step coverage is generally used as an indicator to exhibit the condition of a coating film with respect to the level difference. The step coverage means film thickness of level difference wall surface / film thickness of the surface (%) as a management indicator. In the present invention no step coverage is used. The reason is that the condition of film formation to the inward side surface and the bottom surface produces a problem, and the condition of film formation to the surface layer (attachment surface) is not important. In the case of the widely prevailing evaporation, t₁/t₂ is small, and it is difficult to form a film on the inward side surface. Further, in such the case, a film formed on the inward side surface exhibits low film density, and has a columnar structure, whereby liquid (water) tends to be penetrated. In order to improve this, a film forming method such as a CVD method, a sputtering method, a spray coating method or the like is effective. It was found out in the present invention that the larger t₁/t₂, the smaller difference of density and structure of the film between the inward side surface and the bottom surface was, whereby penetration of liquid (water) was inhibited because of the continuous film formation.

Accordingly, when forming an SiO₂ film so as to give a ratio t₁/t₂ of at least 1/10, for example, and forming a 100 nm thick SiO₂ film on the bottom surface of opening portion 12, an at least 10 nm thick SiO₂ film is formed on the inward side surface, and the spacing at the boundary between the inward side surface of opening portion 12 and the bottom surface of opening portion 12 can be sufficiently filled in.

Similarly, when forming an SiO₂ film so as to give a ratio t₁/t₂ of at least 1/3, and forming a 30 nm thick SiO₂ film on the bottom surface of opening portion 12, an at least 10 nm thick SiO₂ film is formed on the inward side surface, and the spacing at the boundary between the inward side surface of opening portion 12 and the bottom surface of opening portion 12 can be sufficiently filled in.

Similarly, when forming an SiO₂ film so as to give a ratio t₁/t₂ of at least 1/2, and forming a 20 nm thick SiO₂ film on the bottom surface of opening portion 12, an at least 10 nm thick SiO₂ film is formed on the inward side surface, and the spacing at the boundary between the inward side surface of opening portion 12 and the bottom surface of opening portion 12 can be sufficiently filled in.

In such the way, when forming an SiO₂ film so as to approach a ratio t₁/t₂ to 1, the SiO₂ film formed as a whole can be minimized, whereby produced is the effect where cracks and film peeling caused by film stress are difficult to be generated. Further, even in the case of the same thickness, sealing the space at the boundary is highly effective when approaching a ratio t₁/t₂ to 1 as closely as possible.

### (Material for microchip substrate)

Resins are utilized for microchip substrates 10 and 14. These resins should exhibit good molding properties (transferability and a releasing property), high transparency, low self-fluorescence with respect to UV radiation and visible light and so forth as the conditions, but the present invention is not specifically limited thereto. Preferable examples thereof include polycarbonate, polymethylmethacrylate, polystyrene, polyacrylonitril, polyvinyl chloride, polyethylene terephthalate, nylon 6, nylon 66, polyvinyl acetate, polyvinylidene chloride, polypropylene, polyisoprene, polyethylene, polydimethyl siloxane, cyclic polyolefin and so forth. Polymethylmethacrylate and cyclic polyolefin are specifically preferable. The material used for microchip substrate 10 may be identical to that of microchip substrate 14, and the material used for microchip substrate 10 may be different from that of microchip substrate 14.

### (Shape of microchip substrate)

Shape of microchip substrates 10 and 14 may be any shape as long as the shape is one capable of easily handling and easily conducting analysis. For example, the microchip substrate having roughly a square, 10 mm on a square - a square, 200 mm on a square in size is preferable, and the microchip substrate having a square, 10 mm on a square - a square, 100 mm on a square in size is more preferable. Shape of microchip substrates 10 and 14 may be adjusted for an analysis method and an analyzer, and shape such as a square, a rectangle, a circle or the like is preferable.

### (Shape of fine flow path)

Fine flow path 11 preferably has a width of 10 - 200 µm, and a depth of 10 - 200 µm in size in consideration of the reducible consumption amount of an analysis specimen or a reagent, and preparation accuracy, transferability and a releasing property of a molding die. Further, an aspect ratio (depth of groove / width of groove) of roughly 0.1 - 3 is preferable. Further, width and depth of fine flow path 11 may be determined depending on application of a microchip. In addition, in order to clarify the explanation, the cross-sectional shape of fine flow path 11 shown in Fig. 1 is rectangular, but this shape is an example of fine flow path 11, and may be in the form of a curve.

Microchip substrate 10 on which fine flow path 11 is formed preferably has a thickness of 0.2 - 5 mm, and more preferably has a thickness of 0.5 - 2 mm in view of a molding property. Microchip substrate 14 serving as a lid (a cover) to cover fine flow path 11 preferably has a thickness of 0.2 - 5 mm, and more preferably has a thickness of 0.5 - 2 mm in view of a molding property. Further, in cases where no fine flow path is formed on microchip substrate 14 serving as a lid (a cover), a film (a member in the form of a sheet) may be used. In this case, the film preferably has a thickness of 30 - 300 µm, and more preferably has a thickness of 50 - 150 µm.

### (Action and effect)

In accordance with a microchip having the above-described configuration, in the vicinity of opening portion 12 (portion A represented by a dashed circle in Fig. 1), the spacing generated between microchip substrate 10 and microchip substrate 14 is possible to be filled in with dielectric film 13. As the result, leakage of a reagent or the like in the vicinity of opening portion 12 is possible to be prevented. That is, since dielectric film 13 is continuously formed with no fracture from the inward side surface of opening portion 12 to the bottom surface of opening portion 12, the spacing between the substrates can be filled in to prevent leakage of the reagent or the like.

Further, since an SiO₂ film possesses hydrophilic function, water, a reagent or the like is possible to be smoothly introduced into opening portion 12 and fine flow path 11 via capillarity action with no pressure-feeding of water, the reagent or the like, by forming the SiO₂ film in opening portion 12. Further in the case of a TiO₂ film, since hydrophilicity is generated by exposing the TiO₂ film to UV radiation, the same effect as that of the SiO₂ film is possible to be produced by exposing the TiO₂ film to UV radiation, after forming the TiO₂ film in opening portion 12.

### (Manufacturing method)

Next, a method of manufacturing a microchip of the 1^{st} embodiment mentioned above will be described. In the 1^{st} embodiment, after attaching microchip substrates 10 and 14 to each other, dielectric film 13 is formed in opening portion 12 to prepare a microchip of the 1^{st} embodiment.

### (Microchip substrates attached to each other)

Microchip substrate 10 and microchip substrate 14 are attached to each other so as to place the surface on which fine flow path 11 is formed on the inward side. Attaching microchip substrates to each other, for example, can be conducted via thermal fusion, ultrasonic fusion or laser fusion. Further, the surface of a microchip substrate can be activated via UV radiation, plasma or ion beams to attach microchip substrates to each other.

### (Formation of dielectric film)

After attaching microchip substrate 10 and microchip 14 to each other, dielectric film 13 is formed in opening portion 12. Dielectric film 13 can be formed via evaporation, sputtering, CVD or coating, and the film formation method is not specifically limited thereto. The film formation method via coating, sputtering or CVD is a preferable method, since an SiO₂ film exhibiting excellent adhesion can be formed on the inner surface of fine flow path 11, specifically on the wall surface perpendicular to fine flow path 11.

A dielectric film may be formed not only on the inner surface of opening portion 12, but also on the surface of a microchip and fine flow path 11. In cases where a dielectric film is formed only on the inner surface of opening portion 12, dielectric film 13 is formed via masking of the microchip surface (which means the surface of microchip substrate 10, and the surface on the opposite side of the surface on which fine flow path 11 is formed) in such a way that the dielectric film is formed only on the inner surface.

In addition, dielectric film 13 is formed in connection portion B (portion B represented by dashed lines in Fig. 1) to fine flow path 11 by forming dielectric film 13 on the inner surface of opening portion 12, but no formation of dielectric film 13 should be made to such an extent that connection portion B is sealed.

### (Example of dielectric film formation via coating)

In cases where dielectric film 13 is formed in opening portion 12 via coating, a coating solution to prepare a dielectric film after curing is coated on the surface of a microchip, and dielectric film 13 can be subsequently formed on the inner surface of opening 12 by curing the coating solution.

In cases where an SiO₂ film is formed as dielectric film 13, one in which polysiloxane oligomer obtained via hydrolysis and condensation-polymerization of alkoxysilane is dissolved in an alcohol solvent is employed. In this case, the alcohol solvent is volatilized via heating of a coating solution to form the SiO₂ film (dielectric film 13). Specific examples thereof include GLASCA7003 produced by JSR corporation, METHYLSILICATE51 produced by Colcoat Co., Ltd., and so forth.

Further, one in which perhydropolysilazane is dissolved in a solvent of xylene and dibutylether is employed as a coating solution. In this case, at the same time when the coating solution is heated to volatilize the solvent, the SiO₂ film (dielectric film 13) is formed via reaction with water. AQUAMICA produced by AZ Electronic Materials Co., Ltd. and so forth are specifically exemplified.

Further, one in which an inorganic-organic hybrid polymer obtained via hydrolysis·cocondensation of an alkoxysilyl-containing polymer and alkoxysilane is dissolved in an alcohol solvent is employed. In this case, the alcohol solvent is volatilized via heat to form a hybrid film made of SiO₂ as a principal component. GLASCA7506 produced by JSR Corporation and so forth are specifically exemplified.

### (Coating method of coating solution)

It is desired to evenly coat a coating solution in opening portion 12. The coating method is selected appropriately in consideration of matter properties of the coating solution (viscosity and volatilization). Examples thereof include a dipping method, a spray coating method, a spin coating method, a slit coating method, a screen printing method, a pad printing method, an ink-jet printing method and so forth.

Then, an SiO₂ film (dielectric film 13) is formed by curing the coating solution. For example, in cases where a thermosetting coating solution is employed, the coating solution is cured via heat treatment to form an SiO₂ film (dielectric film 13).

### (Method of curing coating solution)

When forming an SiO₂ film (dielectric film 13) by curing a coating solution, it is desired to form a solid network of SiO₂ via sufficient volatilization of solvents in the coating solution. The coating method is selected appropriately in consideration of matter properties of the coating solution (viscosity, volatilization and catalyst). For example, the coating solution is left standing at room temperature for curing; the coating solution is heated at a temperature of 60 - 100 °C for curing; and the coating solution is cured at high temperature and high humidity (at a temperature of 60 °C and a humidity of 90 %, at a temperature of 80 °C and a humidity of 90 % and so forth). Further, the coating solution may be cured utilizing UV curing, visible light curing or the like.

### (Formation example of dielectric film via sputtering)

Further, in cases where an SiO₂ film (dielectric film 13) is formed in opening portion 12 via sputtering, a sputtering apparatus (apparatus name: RAS-1100C) manufactured by Shincron Co., Ltd. is employed to form an SiO₂ film (dielectric film 13). A metal film formation room and an oxidation room for silicon are partitioned, and a drum onto which a substrate is attached is rotated to form an SiO₂ film (dielectric film 13). For example, the SiO₂ film (dielectric film 13) is formed under the conditions of an Ar gas flow rate of 250 sccm, an oxygen gas flow rate of 120 sccm, an RF output of 4.5 kW, and a film formation rate of 4 A/sec.

Further, in cases where a TiO₂ film (dielectric film 13) is formed in opening portion 12 via sputtering, a metal film formation room and an oxidation room for titanium are partitioned, and a drum onto which a substrate is attached is rotated to form a TiO₂ film (dielectric film 13). The TiO₂ film (dielectric film 13) is formed under the conditions of an Ar gas flow rate of 250 sccm, an oxygen gas flow rate of 120 sccm, an RF output of 5.5 kW, and a film formation rate of 2.5 A/sec.

### (Formation example of dielectric film via CVD)

Further, in cases where an SiO₂ film (dielectric film 13) is formed in opening portion 12 via CVD, a CVD apparatus manufactured by Samco Inc., for example, is employed to form an SiO₂ film (dielectric film 13). A liquid source containing silicon such as TEOS (Tetra Ethoxy Silane), TMOS (Tetra Methoxy Silane) or the like is vaporized, decomposed in plasma space, and oxidized to form an SiO₂ film (dielectric film 13). For example, an SiO₂ film (dielectric film 13) is formed under the conditions of a TEOS flow rate of 12 sccm, an oxygen gas flow rate of 400 sccm, an RF output of 300 W, a pressure of 50 Pa, and a film formation rate of 30 A/sec.

### (Formation of dielectric film into fine follow path 11)

Further, a dielectric film (SiO₂ film, or TiO₂ film exposed to UV radiation) may be formed on the inner surface of fine flow path 11 in order to provide hydrophilic function to fine flow path 11. In this case, a dielectric film is formed on the surface where fine flow path 11 of microchip substrate 10 is formed, and further, a dielectric film is formed on the attachment surface of another microchip substrate 14. After this, microchip substrate 10 and microchip substrate 14 are attached to each other. In order to attach microchip substrates to each other, surface activation attachment employing UV radiation, plasma or ion-beams is preferable. That is, the surface (attachment surface), on which the dielectric film of each of microchip substrates 10 and 14 is formed, is exposed to UV radiation, plasma or ion-beams to attach microchip substrates 10 and 14 to each other by activating the attachment surface. After attaching substrates to each other, dielectric film 13 is formed on the inner surface of opening portion 12. The same effect as described above can be obtained by forming dielectric film 13 on the inner surface of opening portion 12, and it is further possible to improve reaction stability and reproduction since the inner surface of fine flow path 11 is covered by the dielectric film.

Further, the dielectric film may be formed entirely on the inner surface of opening portion 12 and the inner surface of fine flow path 11. In order to realize this, microplasma is effective. The microplasma is generally a gas discharge in the very fine space, using high frequency and microwaves of from RF to VHF and UHF range. It is possible to form an SiO₂ film or a TiO₂ film on the inner surface of fine flow path 11 by introducing raw material vaporized in this microplasma, and decomposing it via plasma.

Since an SiO₂ film or a TiO₂ film exposed to UV radiation exhibits hydrophilicity, it becomes possible to inhibit attachment of a low molecule or a high molecule such as a protein or the like onto the inner surface of film flow path 11. Since each of microchips 10 and 14 each are made of a resin, it gradually exhibits hydrophilicity, and a low molecule or a high molecule such as a protein or the like is easy to be attached into fine flow path 11, but it becomes possible to inhibit the attachment by forming an SiO₂ film or a TiO₂ film exposed to UV radiation.

Further, since an SiO₂ film is chemically stable, hydrophilic function can be stably maintained. The surfaces of microchip substrates 10 and 14 each made of a resin, which is subjected to a plasma treatment, to conduct a hydrophilization treatment, but the effect is reduced with time, whereby hydrophilic function tends to be reduced within several days. Further, A high molecule such as oligoethylene glycol, 2-methacryloyl phosphorylcholine or the like is possible to be surface-modified on the surface of each of microchip substrates 10 and 14 via dipping to conduct a a hydrophilization treatment, but the evenly hydrophilic surface can not be frequently obtained because of weak adsorption force of a surface-modifying group and generation of unevenness.

In contrast, it becomes possible to form the identical surface condition, even though microchip substrates 10 and 14 each are made of a different resin material by forming an SiO₂ film on microchip substrate 10 on which fine flow path 11 is formed, and on microchip substrate 14 serving as a lid (a cover). By this, it becomes possible to increase analysis accuracy and reliability. In the case of the different surface condition of the substrate, fluctuation in flow rate and reaction of the analyzed liquid is generated, resulting in a problem such that detection sensitivity of an analysis chip is lowered. It becomes possible to inhibit generation of the fluctuation, and to improve the detection sensitivity of the analysis chip.

### (Formation of dielectric film on the surface of microchip)

Further, a dielectric film may be formed only on the inner surface of opening portion 12, and also formed on the surface of a microchip. The effect of exhibiting excellent abrasion-resistance of the microchip surface is produced by forming a dielectric film on the microchip surface. In addition, in an example shown in Fig. 1, dielectric film 13 is formed not only in opening portion 12, but also on the microchip surface. The details will be explained here, and dielectric film 13 provided on the surface of microchip substrate 10 is formed also on the surface on the opposite side of the surface on which fine flow path 11 is formed. Further, dielectric films may be formed on both surfaces of the microchip. That is, no figure is shown, but with respect to microchip substrate 14, a dielectric film may be formed on the surface on the opposite side of the attachment surface.

### [The 2^{nd} embodiment]

Next, a microchip in the 2^{nd} embodiment of the present invention and a method of manufacturing the microchip will be described referring to Fig. 2. Fig. 2 is a cross-sectional view of a microchip in the 2^{nd} embodiment of the present invention. In the 2^{nd} embodiment, a through-hole was formed in a microchip substrate serving as a lid (a cover).

A microchip of the 2^{nd} embodiment possesses microchip 20 and microchip 22. Groove-shaped fine flow path 21 is formed on microchip substrate 20. Microchip substrate 22 as the other one attached onto microchip substrate 20 is a substrate in the form of a flat plate. In the 2^{nd} embodiment, a through-hole is formed in microchip substrate 22. Microchip substrate 20 and microchip substrate 22 are attached to each other so as to place the surface on which fine flow path 21 on the inward side. By this, microchip substrate 22 serves as a lid (a cover) of fine flow path 21, and a through-hole formed in microchip substrate 22 becomes opening portion 23. A through-hole is aligned on the position of fine flow path 21 on microchip substrate 20 to form the through-hole in microchip substrate 22, whereby opening portion 23 can be communicated with fine flow path 21. A tube and a nozzle installed in an analyzer are connected to opening portion 23, gel, a specimen, a buffer solution or the like is introduced into fine flow path 21, or discharged from fine flow path 21 via the tube and the nozzle. In addition, microchip substrates 20 and 22 correspond to an example of "substrate made of a resin" of the present invention.

Further, similarly to the 1^{st} embodiment, dielectric film 24 (SiO₂ film or TiO₂) is formed on the inner surface of opening portion 23. That is, dielectric film 24 is continuously formed with no rupture from the inward side surface of opening portion 23 to the bottom surface of opening portion 23. And, at the boundary between the inward side surface of opening portion 23 and the bottom surface of opening portion 23, dielectric film 24 is formed in a state where it is filled in. Dielectric film 24 has the same thickness as described in the 1^{st} embodiment. Further, a ratio (t₁/t₂) of thickness t₁ of dielectric film 24a formed on the inward side surface of opening portion 23 to thickness t₂ of dielectric film 24b formed on the bottom surface of opening portion 23 is preferably at least 1/10, more preferably at least 1/3, and still more preferably at least 1/2.

Further, similarly to the 1^{st} embodiment, as each material utilized for microchip substrate 20 and microchip substrate 22, a resin is employed, dimensions of microchip substrates 20 and 22 and shape of fine flow path 21 are identical to those described in the 1^{st} embodiment.

### (Manufacturing method)

Similarly to the 1^{st} embodiment, after attaching microchip substrates 20 and 22 to each other, dielectric film 24 is formed in opening portion 23 to prepare a microchip of the 2^{nd} embodiment. A method of attaching microchip substrates 20 and 22 to each other, and a method of forming a dielectric film are the same method as described in the 1^{st} embodiment. Further, a dielectric film may be formed not only in opening portion 23, but also on the inner surface of fine flow path 21, and a dielectric film may also be formed on the surface of a microchip.

### (Action and effect)

In accordance with a microchip having the above-described configuration, similarly to the 1^{st} embodiment, in the vicinity of opening portion 23 (portion C represented by a dashed circle in Fig. 2), the spacing generated between microchip substrate 20 and microchip substrate 22 is possible to be filled in with dielectric film 24. As the result, leakage of a reagent or the like in the vicinity of opening portion 23 is possible to be prevented.

### [The 3^{rd} embodiment]

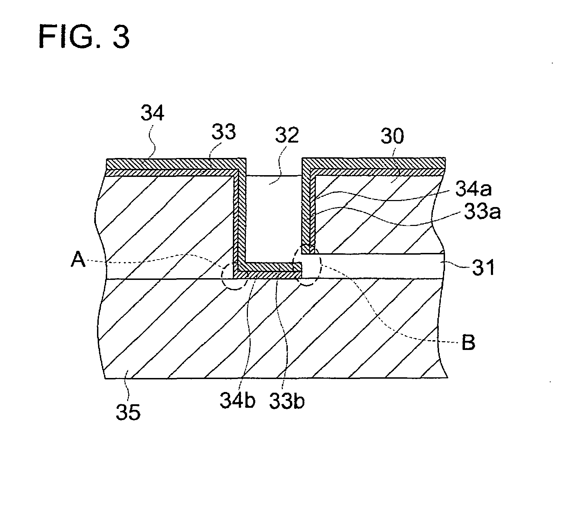

Next, a microchip in the 3^{rd} embodiment of the present invention and a method of manufacturing the microchip will be described referring to Fig. 3. Fig. 3 is a cross-sectional view of a microchip in the 3^{rd} embodiment of the present invention. In the 3^{rd} embodiment, a through-hole was formed in a microchip substrate on which a fine flow path is formed to form a dielectric film composed of two layers in the opening portion.

### (Configuration of microchip)

The microchip in the 3^{rd} embodiment is fitted with microchip substrate 30 and microchip substrate 35. Fine flow path 31 in the form of a groove is formed on microchip substrate 30. Further, a through-hole passing through the substrate is formed in microchip substrate 30. This through-hole is formed so as to be brought into contact with fine flow path 31 to produce opening portion 32 by attaching microchip substrate 30 onto microchip substrate 35. Microchip substrate 35 as the other one to be attached onto microchip substrate 30 is a substrate in the form of a flat plate. Microchip substrate 30 and microchip substrate 35 are attached to each other so as to place the surface on which fine flow path 31 is formed on the inward side. By this, microchip substrate 35 serves as a lid of fine flow path 31 (a cover), and a through-hole formed in microchip substrate 30 becomes opening portion 32. Since a through-hole of microchip substrate 30 is formed so as to be brought into contact with fine flow path 31, opening portion 32 originated from the through-hole is communicated with fine flow path 31. In addition, each of microchip substrates 30 and 35 corresponds to an example for "a substrate made of a resin" of the present invention.

Further, 1^{st} dielectric film 33 is formed on the inner surface of opening portion 32, and 2^{nd} dielectric film 34 is layered on 1^{st} dielectric film 33. Each of utilized 1^{st} dielectric film 33 and 2^{nd} dielectric film 34 is made of a different material. Similarly to the 1^{st} embodiment, 1^{st} dielectric film 33 and 2^{nd} dielectric film 34 are continuously formed with no rupture from the inward side surface of opening portion 32 to the bottom surface of opening portion 32.

The total film thickness of 1^{st} dielectric film 33 and 2^{nd} dielectric film 34 is determined in consideration of the inner surface of opening portion 32 covered by 1^{st} dielectric film 33 and 2^{nd} dielectric film 34, acquisition of adhesion to the inner surface of opening portion 32, no sealing of fine flow path 31 and so forth. In cases where a dielectric film composed of two layers is formed via coating, the film thickness is adjusted depending on properties and kinds of a coating solution. The 1^{st} dielectric film 33 and 2^{nd} dielectric film 34 preferably have a total film thickness of 10 nm - 3 µm, and more preferably have a total film thickness of 10 nm - 2 µm. Further, in cases where a dielectric film composed of two layers is formed via sputtering or CVD, the dielectric film preferably have a total film thickness of 10 nm - 1 µm, and more preferably have a total film thickness of 50 nm - 500 nm, since internal stress of the dielectric film tends to be increased.

Further, a ratio (t₁/t₂) of total thickness t₁ of 1^{st} dielectric film 33a and 2^{nd} dielectric film 34a formed on the inward side surface of opening portion 32 to total thickness t₂ of 1^{st} dielectric film 33b and 2^{nd} dielectric film 34b formed on the bottom surface of opening portion 32 is preferably at least 1/10, more preferably at least 1/3, and still more preferably at least 1/2.

Further, similarly to the 1^{st} embodiment, as each material utilized for microchip substrate 30 and microchip substrate 35, a resin is employed, dimensions of microchip substrates 30 and 35, and shape of fine flow path 31 are identical to those described in the 1^{st} embodiment.

### (Manufacturing method)

Similarly to the 1^{st} embodiment, after attaching microchip substrates 30 and 35 to each other, 1^{st} dielectric film 33 and 2^{nd} dielectric film 34 are formed in opening portion 32 to prepare a microchip of the 3^{rd} embodiment. Specifically, 1^{st} dielectric film 33 is formed in opening portion 32, and then 2^{nd} dielectric film 34 is formed on 1^{st} dielectric film 33. Further, a method of attaching microchip substrates to each other, and a method of forming a dielectric film are the same method as described in the 1^{st} embodiment. Further, a dielectric film may be formed not only in opening portion 32, but also on the inner surface of fine flow path 31, and a dielectric film may also be formed on the surface of a microchip.

In addition, a dielectric film is also formed in connection portion B (portion B represented by dashed lines in Fig. 1) to fine flow path 31 by forming the dielectric film on the inner surface of opening portion 32, but no formation of the dielectric film should be made to such an extent that connection portion B is sealed.

### (Action and effect)

In accordance with a microchip having the above-described configuration, similarly to the 1^{st} embodiment, in the vicinity of opening portion 32 (portion A represented by a dashed circle in Fig. 3), the spacing generated between microchip substrate 30 and microchip substrate 35 is possible to be filled in with dielectric film 33. As the result, leakage of a reagent or the like in the vicinity of opening portion 32 is possible to be prevented.

The surface of a microchip is capable of serving as an antireflection film by laminating 1^{st} dielectric film 33 and 2^{nd} dielectric film 34 on the surface of the microchip. By this, when detecting a specimen via exposure to light from the side of the surface on which the dielectric films are formed, during analysis employing a microchip of the 3^{rd} embodiment, it is possible to improve light use efficiency.

In addition, in the above-described 1^{st}, 2^{nd} and 3^{rd} embodiments, a fine flow path is formed on one microchip substrate, and a through-hole to form an opening portion is formed in another microchip substrate. In the present invention, a fine flow path may be formed on at least one of two microchip substrates, and a through-hole to form an opening portion may further be formed in at least one of the two microchip substrates. Accordingly, fine flow paths may be formed on both of the microchip substrates, and through-holes to form opening portions may also be formed in both of the microchip substrates.

### EXAMPLE

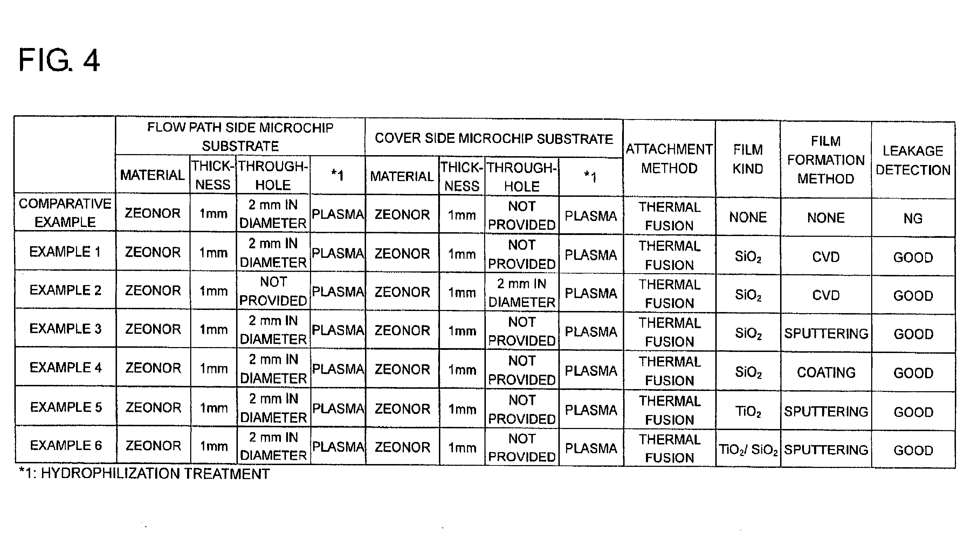

Next, specific examples will be described referring to Fig. 4. Fig. 4 is a table showing the conditions of Examples and Comparative example. First, Comparative example will be explained in comparison to Examples, and then Examples will be described.

### (Comparative example)

In Comparative example, evaluation was made by preparing a microchip of the prior art shown in Fig. 7.

### (Microchip substrate)

A cyclic polyolefin resin as a transparent resin material (ZEONOR, produced by Zeon Corporation) was molded with an injection molding machine to prepare a flow path side microchip substrate possessing a plurality of fine flow paths each having a width of 50 µm and a depth of 50 µm on a plate-shaped member having an outline dimension of 50 mm x 50 mm x 1 mm, and a plurality of through-holes each having an inner diameter of 2 mm thereof. This flow path side microchip substrate corresponds to microchip substrate 110 on which fine flow path 111 is formed, as shown in Fig. 7. Further, similarly, a cover side microchip substrate having an outline dimension of 50 mm x 50 mm x 1 mm was prepared. This cover side microchip substrate corresponds to microchip substrate 120 shown in Fig. 7. Since the inner surface of the fine flow path was subjected to a hydrophilization treatment, the surface on which the fine flow path of the flow path side microchip substrate was formed, and the surface of the cover side microchip substrate were exposed to plasma.

Then, the flow path side microchip substrate and the cover side microchip substrate were attached to each other so as to place the fine flow path on the inner side, maintaining the conditions of 120 °C and 1 kgf/cm² for 1 minute employing a hot press machine to attach the substrates to each other. By this, an opening portion (corresponding to opening portion 112 in Fig. 7) having an inner diameter of 2 mm and a depth of 1 mm was formed.

### (Evaluation)

When a microchip of Comparative example was connected to a syringe pump to feed water at a pressure of 0.13 MPa, the fine flow path could run water, but water was leaked in the vicinity of the opening portion. Such the water leakage causes inaccurate mixture of the specimen, whereby unfavorable insulation breakdown tends to occur during electrophoresis. As the cause of water leakage from the opening portion, it would appear that slight mold distortion remained in the vicinity of the opening portion, and the spacing between the flow path side microchip substrate and the cover side microchip substrate was produced in the vicinity of the opening portion.

### (Example 1)

In Example 1, a specific example of a microchip in the 1^{st} embodiment will be described.

### (Microchip substrate)

A cyclic polyolefin resin as a transparent resin material (ZEONOR, produced by Zeon Corporation) was molded with an injection molding machine to prepare a flow path side microchip substrate possessing a plurality of fine flow paths each having a width of 50 µm and a depth of 50 µm on a plate-shaped member having an outline dimension of 50 mm x 50 mm x 1 mm, and a plurality of through-holes each having an inner diameter of 2 mm thereof. This flow path side microchip substrate corresponds to microchip substrate 10 on which fine flow path 11 in the above-described 1^{st} embodiment is formed. Further, similarly, a cover side microchip substrate having an outline dimension of 50 mm x 50 mm x 1 mm was prepared. This cover side microchip substrate corresponds to microchip substrate 14 serving as a lid (a cover) of the 1^{st} embodiment. Since the inner surface of the fine flow path was subjected to a hydrophilization treatment, the surface on which the fine flow path of the flow path side microchip substrate was formed, and the surface of the cover side microchip substrate were exposed to plasma.

Then, the flow path side microchip substrate and the cover side microchip substrate were attached to each other so as to place the fine flow path on the inner side, maintaining the conditions of 120 °C and 1 kgf/cm² for 1 minute employing a hot press machine to attach the substrates to each other. By this, an opening portion (corresponding to opening portion 12 in the 1^{st} embodiment) having an inner diameter of 2 mm and a depth of 1 mm was formed.

### (Formation of SiO₂ film)

In Example 1, an SiO₂ film was employed as a dielectric film to form the SiO₂ film via CVD. Specifically, an SiO₂ film having a thickness of 200 nm was formed on the inner surface of the opening portion formed in the microchip which was subjected to an attachment process, employing a CVD apparatus (PD-270ST, manufactured by Samco, Inc.). TEOS (produced by ADEKA Corporation) was used as CVD raw material. The SiO₂ film was able to be formed on the inner surface (the inward side surface and the bottom surface) of an opening portion having an inner diameter of 2 mm and a depth of 1 mm. An SiO₂ film formed on the inward side surface of the opening portion had a thickness t₁ of 150 nm, and Another SiO₂ film formed on the bottom surface had a thickness t₂ of 200 nm. In this case, a ratio t₁/t₂ is 0.75 (= 150/200), resulting in at least 1/2.

Further, an SiO₂ film may be formed by masking the surface of a microchip so as to form the SiO₂ film only on the inner surface of an opening portion, and may also be formed via no masking of the surface. The effect of exhibiting excellent abrasion-resistance with respect to the microchip surface is produced by forming the SiO₂ film on the surface of a microchip. Further, masking cost can be reduced. In the case of Example 1, an SiO₂ film was formed with no masking on the side of the flow path side microchip substrate on which an opening portion (through-hole) is formed.

### (Evaluation)

When a microchip of Example 1 was connected to a syringe pump to feed water at a pressure of 0.13 MPa, no liquid leaked from the fine flow path and the vicinity of the opening portion, resulting in sufficient sealing performance. The following means after attaching the flow path side microchip substrate and the cover side microchip substrate to each other, and similarly to Comparative example, the spacing between the flow path side microchip substrate and the cover side microchip substrate was produced in the vicinity of the opening portion before forming an SiO₂ film in the opening portion, but it would appear that the spacing was possible to be filled in by forming the SiO₂ film on the inner surface of the opening portion.

Further, when the cross-section of the microchip in Example 1 was prepared with a microtome, and the cross-section was observed with an electron microscope, it was confirmed that the SiO₂ film was evenly formed with no rupture on the inner surface of an opening portion. By this, it was confirmed that the SiO₂ film served as the function to prevent the liquid leakage in the vicinity of the opening portion.

Further, since the inner surface of the opening portion was covered by a hydrophilic SiO₂ film, it was confirmed that water, a reagent or the like was possible to be smoothly introduced into the opening portion and the fine flow path via capillarity action with no pressure-feeding of water, the reagent or the like.

### (Example 2)

In Example 2, a specific example of a microchip in the 2^{nd} embodiment will be described.

### (Microchip substrate)

A cyclic polyolefin resin as a transparent resin material (ZEONOR, produced by Zeon Corporation) was molded with an injection molding machine to prepare a flow path side microchip substrate possessing a plurality of fine flow paths each having a width of 50 µm and a depth of 50 µm on a plate-shaped member having an outline dimension of 50 mm x 50 mm x 1 mm. This flow path side microchip substrate corresponds to microchip substrate 20 on which fine flow path 21 in the above-described 2^{nd} embodiment is formed. Further, similarly prepared was a cover side microchip substrate in which a plurality of through-holes each having an inner diameter of 2mm were formed in a plate-shaped member having an outline dimension of 50 mm x 50 mm x 1 mm. This cover side microchip substrate corresponds to microchip substrate 22 serving as a lid (a cover) in the 2^{nd} embodiment. Since the inner surface of the fine flow path was subjected to a hydrophilization treatment, the surface on which the fine flow path of the flow path side microchip substrate was formed, and the surface of the cover side microchip substrate were exposed to plasma.

Then, the flow path side microchip substrate and the cover side microchip substrate were attached to each other so as to place the fine flow path on the inner side, maintaining the conditions of 120 °C and 1 kgf/cm² for 1 minute employing a hot press machine to attach the substrates to each other. By this, an opening portion (corresponding to opening portion 23 in the 2^{nd} embodiment) having an inner diameter of 2 mm and a depth of 1 mm was formed.

### (Formation of SiO₂ film)

In Example 2, an SiO₂ film was employed as a dielectric film to form the SiO₂ film via CVD. An SiO₂ film having a thickness of 200 nm was formed on the inner surface of the opening portion formed in the microchip which was subjected to an attachment process, employing a CVD apparatus (PD-270ST, manufactured by Samco, Inc.). TEOS (produced by ADEKA Corporation) was used as CVD raw material. The SiO₂ film was able to be formed on the inner surface (the inward side surface and the bottom surface) of an opening portion having an inner diameter of 2 mm and a depth of 1 mm. An SiO₂ film formed on the inward side surface of the opening portion had a thickness t₁ of 150 nm, and another SiO₂ film formed on the bottom surface had a thickness t₂ of 200 nm. In this case, a ratio t₁/t₂ is 0.75 (= 150/200), resulting in at least 1/2.

Further, an SiO₂ film may be formed by masking the surface of a microchip so as to form the SiO₂ film only on the inner surface of an opening portion, and may also be formed via no masking of the surface. The effect of exhibiting excellent abrasion-resistance with respect to the microchip surface is produced by forming the SiO₂ film on the surface of a microchip. Further, masking cost can be reduced. In the case of Example 2, an SiO₂ film was formed with no masking on the side of the cover side microchip substrate on which an opening portion (through-hole) is formed.

### (Evaluation)

When a microchip of Example 2 was connected to a syringe pump to feed water at a pressure of 0.13 MPa, no liquid leaked from the fine flow path and the vicinity of the opening portion, resulting in sufficient sealing performance. The following means after attaching the flow path side microchip substrate and the cover side microchip substrate to each other, and similarly to Comparative example, the spacing between the flow path side microchip substrate and the cover side microchip substrate was produced in the vicinity of the opening portion before forming an SiO₂ film in the opening portion, but it would appear that the spacing was possible to be filled in by forming the SiO₂ film on the inner surface of the opening portion.

Further, when the cross-section of the microchip in Example 2 was prepared with a microtome, and the cross-section was observed with an electron microscope, it was confirmed that the SiO₂ film was evenly formed with no rupture on the inner surface of an opening portion. By this, it was confirmed that the SiO₂ film served as the function to prevent the liquid leakage in the vicinity of the opening portion.

Further, since the inner surface of the opening portion was covered by a hydrophilic SiO₂ film, it was confirmed that water, a reagent or the like was possible to be smoothly introduced into the opening portion and the fine flow path via capillarity action with no pressure-feeding of water, the reagent or the like.

### (Example 3)

In Example 3, a specific example of a microchip in the 1^{st} embodiment will be described.

### (Microchip substrate)

A cyclic polyolefin resin as a transparent resin material (ZEONOR, produced by Zeon Corporation) was molded with an injection molding machine to prepare a flow path side microchip substrate possessing a plurality of fine flow paths each having a width of 50 µm and a depth of 50 µm and a plurality of through-holes each having an inner diameter of 2 mm on a plate-shaped member having an outline dimension of 50 mm x 50 mm x 1 mm. This flow path side microchip substrate corresponds to microchip substrate 10 on which fine flow path 11 in the above-described 1^{st} embodiment is formed. Further, similarly prepared was a cover side microchip substrate having an outline dimension of 50 mm x 50 mm x 1 mm. This cover side microchip substrate corresponds to microchip substrate 14 serving as a lid (a cover) in the 1^{st} embodiment. Since the inner surface of the fine flow path was subjected to a hydrophilization treatment, the surface on which the fine flow path of the flow path side microchip substrate was formed, and the surface of the cover side microchip substrate were exposed to plasma.

Then, the flow path side microchip substrate and the cover side microchip substrate were attached to each other so as to place the fine flow path on the inner side, maintaining the conditions of 120 °C and 1 kgf/cm² for 1 minute employing a hot press machine to attach the substrates to each other. By this, an opening portion (corresponding to opening portion 12 in the 1^{st} embodiment) having an inner diameter of 2 mm and a depth of 1 mm was formed.

### (Formation of SiO₂ film)

In Example 3, an SiO₂ film was employed as a dielectric film to form the SiO₂ film via sputtering. Specifically, an SiO₂ film having a thickness of 200 nm was formed on the inner surface of the opening portion formed in the microchip which was subjected to an attachment process, employing a sputtering apparatus (RAS-1100C, manufactured by Shincron Co., Ltd). A SiO₂ film was able to be evenly formed on the inner surface (the inward side surface and the bottom surface) of an opening portion having an inner diameter of 2 mm and a depth of 1 mm, employing a sputtering apparatus. An SiO₂ film formed on the inward side surface of the opening portion had a thickness t₁ of 150 nm, and another SiO₂ film formed on the bottom surface had a thickness t₂ of 200 nm. In this case, a ratio t₁/t₂ is 0.75 (= 150/200), resulting in at least 1/2.

Further, an SiO₂ film may be formed by masking the surface of a microchip so as to form the SiO₂ film only on the inner surface of an opening portion, and may also be formed via no masking of the surface. The effect of exhibiting excellent abrasion-resistance with respect to the microchip surface is produced by forming the SiO₂ film on the surface of a microchip. Further, masking cost can be reduced. In the case of Example 3, an SiO₂ film was formed with no masking on the side of the flow path side microchip substrate on which an opening portion (through-hole) is formed.

### (Evaluation)

When a microchip of Example 3 was connected to a syringe pump to feed water at a pressure of 0.13 MPa, no liquid leaked from the fine flow path and the vicinity of the opening portion, resulting in sufficient sealing performance. The following means after attaching the flow path side microchip substrate and the cover side microchip substrate to each other, and similarly to Comparative example, the spacing between the flow path side microchip substrate and the cover side microchip substrate was produced in the vicinity of the opening portion before forming an SiO₂ film in the opening portion, but it would appear that the spacing was possible to be filled in by forming the SiO₂ film on the inner surface of the opening portion.

Further, when the cross-section of the microchip in Example 3 was prepared with a microtome, and the cross-section was observed with an electron microscope, it was confirmed that the SiO₂ film was evenly formed with no rupture on the inner surface of an opening portion. By this, it was confirmed that the SiO₂ film served as the function to prevent the liquid leakage in the vicinity of the opening portion.

Further, since the inner surface of the opening portion was covered by a hydrophilic SiO₂ film, it was confirmed that water, a reagent or the like was possible to be smoothly introduced into the opening portion and the fine flow path via capillarity action with no pressure-feeding of water, the reagent or the like.

### (Example 4)

In Example 4, a specific example of a microchip in the 1^{st} embodiment will be described.

### (Microchip substrate)

A cyclic polyolefin resin as a transparent resin material (ZEONOR, produced by Zeon Corporation) was molded with an injection molding machine to prepare a flow path side microchip substrate possessing a plurality of fine flow paths each having a width of 50 µm and a depth of 50 µm and a plurality of through-holes each having an inner diameter of 2 mm on a plate-shaped member having an outline dimension of 50 mm x 50 mm x 1 mm. This flow path side microchip substrate corresponds to microchip substrate 10 on which fine flow path 11 in the above-described 1^{st} embodiment is formed. Further, similarly prepared was a cover side microchip substrate having an outline dimension of 50 mm x 50 mm x 1 mm. This cover side microchip substrate corresponds to microchip substrate 14 serving as a lid (a cover) in the 1^{st} embodiment. Since the inner surface of the fine flow path was subjected to a hydrophilization treatment, the surface on which the fine flow path of the flow path side microchip substrate was formed, and the surface of the cover side microchip substrate were exposed to plasma.

Then, the flow path side microchip substrate and the cover side microchip substrate were attached to each other so as to place the fine flow path on the inner side, maintaining the conditions of 120 °C and 1 kgf/cm² for 1 minute employing a hot press machine to attach the substrates to each other. By this, an opening portion (corresponding to opening portion 12 in the 1^{st} embodiment) having an inner diameter of 2 mm and a depth of 1 mm was formed.

### (Formation of SiO₂ film)

In Example 4, an SiO₂ film was employed as a dielectric film to form the SiO₂ film via coating. Specifically, an SiO₂ coating film (AQUAMICA produced by AZ Electronic Materials Co., Ltd.) was coated so as to give a thickness of 1 µm on the inner surface of the opening portion formed in the microchip which was subjected to an attachment process, employing a spray coater (USC-200ST, manufactured by Ushio Inc.). Then, the resulting was placed in an oven at 100 °C for one hour for temporary curing. At this point, since no reaction was sufficiently conducted with water, a slight amount of an organic component was contained. In this case, the resulting was charged in a high temperature-high humidity oven for 3 hours to form an SiO₂ film. The SiO₂ film was able to be evenly formed on the inner surface (the inward side surface and the bottom surface) of an opening portion having an inner diameter of 2 mm and a depth of 1 mm, employing a spray coater. An SiO₂ film formed on the inward side surface of the opening portion had a thickness t₁ of 0.55 µm, and another SiO₂ film formed on the bottom surface had a thickness t₂ of 1 µm. In this case, a ratio t₁/t₂ is 0.55 (= 0.55/1), resulting in at least 1/2.

Further, an SiO₂ film may be formed by masking the surface of a microchip so as to form the SiO₂ film only on the inner surface of an opening portion, and may also be formed via no masking of the surface. The effect of exhibiting excellent abrasion-resistance with respect to the microchip surface is produced by forming the SiO₂ film on the surface of a microchip. Further, masking cost can be reduced. In the case of Example 4, an SiO₂ film was formed with no masking on the side of the flow path side microchip substrate on which an opening portion (through-hole) is formed.

### (Evaluation)

When a microchip of Example 4 was connected to a syringe pump to feed water at a pressure of 0.13 MPa, no liquid leaked from the fine flow path and the vicinity of the opening portion, resulting in sufficient sealing performance. The following means after attaching the flow path side microchip substrate and the cover side microchip substrate to each other, and similarly to Comparative example, the spacing between the flow path side microchip substrate and the cover side microchip substrate was produced in the vicinity of the opening portion before forming an SiO₂ film in the opening portion, but it would appear that the spacing was possible to be filled in by forming the SiO₂ film on the inner surface of the opening portion.

Further, when the cross-section of the microchip in Example 4 was prepared with a microtome, and the cross-section was observed with an electron microscope, it was confirmed that the SiO₂ film was evenly formed with no rupture on the inner surface of an opening portion. By this, it was confirmed that the SiO₂ film served as the function to prevent the liquid leakage in the vicinity of the opening portion.

Further, since the inner surface of the opening portion was covered by a hydrophilic SiO₂ film, it was confirmed that water, a reagent or the like was possible to be smoothly introduced into the opening portion and the fine flow path via capillarity action with no pressure-feeding of water, the reagent or the like.

### (Example 5)

In Example 5, a specific example of a microchip in the 1^{st} embodiment will be described.

### (Microchip substrate)

A cyclic polyolefin resin as a transparent resin material (ZEONOR, produced by Zeon Corporation) was molded with an injection molding machine to prepare a flow path side microchip substrate possessing a plurality of fine flow paths each having a width of 50 µm and a depth of 50 µm and a plurality of through-holes each having an inner diameter of 2 mm on a plate-shaped member having an outline dimension of 50 mm x 50 mm x 1 mm. This flow path side microchip substrate corresponds to microchip substrate 10 on which fine flow path 11 in the above-described 1^{st} embodiment is formed. Further, similarly prepared was a cover side microchip substrate having an outline dimension of 50 mm x 50 mm x 1 mm. This cover side microchip substrate corresponds to microchip substrate 14 serving as a lid (a cover) in the 1^{st} embodiment. Since the inner surface of the fine flow path was subjected to a hydrophilization treatment, the surface on which the fine flow path of the flow path side microchip substrate was formed, and the surface of the cover side microchip substrate were exposed to plasma.

Then, the flow path side microchip substrate and the cover side microchip substrate were attached to each other so as to place the fine flow path on the inner side, maintaining the conditions of 120 °C and 1 kgf/cm² for 1 minute employing a hot press machine to attach the substrates to each other. By this, an opening portion (corresponding to opening portion 12 in the 1^{st} embodiment) having an inner diameter of 2 mm and a depth of 1 mm was formed.

### (Formation of TiO₂ film)

In Example 5, a TiO₂ film was employed as a dielectric film to form the TiO₂ film via sputtering.

Specifically, a TiO₂ film having a thickness of 200 nm was formed on the inner surface of the opening portion formed in the microchip which was subjected to an attachment process, employing a sputtering apparatus (RAS-1100C, manufactured by Shincron Co., Ltd). A TiO₂ film was able to be evenly formed on the inner surface (the inward side surface and the bottom surface) of an opening portion having an inner diameter of 2 mm and a depth of 1 mm, employing a sputtering apparatus. A TiO₂ film formed on the inward side surface of the opening portion had a thickness t₁ of 150 nm, and another TiO₂ film formed on the bottom surface had a thickness t₂ of 200 nm. In this case, a ratio t_{1/}t₂ is 0.75 (= 150/200), resulting in at least 1/2.

Further, a TiO₂ film may be formed by masking the surface of a microchip so as to form the TiO₂ film only on the inner surface of an opening portion, and may also be formed via no masking of the surface. The effect of exhibiting excellent abrasion-resistance with respect to the microchip surface is produced by forming the TiO₂ film on the surface of a microchip. Further, masking cost can be reduced. In the case of Example 5, a TiO₂ film was formed with no masking on the side of the flow path side microchip substrate on which an opening portion (through-hole) is formed.

### (Evaluation)

When a microchip of Example 5 was connected to a syringe pump to feed water at a pressure of 0.13 MPa, no liquid leaked from the fine flow path and the vicinity of the opening portion, resulting in sufficient sealing performance. The following means after attaching the flow path side microchip substrate and the cover side microchip substrate to each other, and similarly to Comparative example, the spacing between the flow path side microchip substrate and the cover side microchip substrate was produced in the vicinity of the opening portion before forming an TiO₂ film in the opening portion, but it would appear that the spacing was possible to be filled in by forming the TiO₂ film on the inner surface of the opening portion.

Further, when the cross-section of the microchip in Example 5 was prepared with a microtome, and the cross-section was observed with an electron microscope, it was confirmed that the TiO₂ film was evenly formed with no rupture on the inner surface of an opening portion. By this, it was confirmed that the TiO₂ film served as the function to prevent the liquid leakage in the vicinity of the opening portion.

Further, a TiO₂ film exhibits hydrophilicity via exposure to UV radiation. Conducted was the experiment by which a microchip fitted with a TiO₂ film was exposed to UV radiation at an intensity of 1 mW/cm² for one minute, and subsequently, water was introduced. As a result, since the TiO₂ film exhibits hydrophilicity, it was confirmed that water was possible to be smoothly introduced into the opening portion and the fine flow path via capillarity action with no pressure-feeding of water.

### (Example 6)

In Example 6, a specific example of a microchip in the 3^{rd} embodiment will be described.

### (Microchip substrate)

A cyclic polyolefin resin as a transparent resin material (ZEONOR, produced by Zeon Corporation) was molded with an injection molding machine to prepare a flow path side microchip substrate possessing a plurality of fine flow paths each having a width of 50 µm and a depth of 50 µm and a plurality of through-holes each having an inner diameter of 2 mm on a plate-shaped member having an outline dimension of 50 mm x 50 mm x 1 mm. This flow path side microchip substrate corresponds to microchip substrate 30 on which fine flow path 31 in the above-described 3^{rd} embodiment is formed. Further, similarly prepared was a cover side microchip substrate having an outline dimension of 50 mm x 50 mm x 1 mm. This cover side microchip substrate corresponds to microchip substrate 35 serving as a lid (a cover) in the 1^{st} embodiment. Since the inner surface of the fine flow path was subjected to a hydrophilization treatment, the surface on which the fine flow path of the flow path side microchip substrate was formed, and the surface of the cover side microchip substrate were exposed to plasma.

Then, the flow path side microchip substrate and the cover side microchip substrate were attached to each other so as to place the fine flow path on the inner side, maintaining the conditions of 120 °C and 1 kgf/cm² for 1 minute employing a hot press machine to attach the substrates to each other. By this, an opening portion (corresponding to opening portion 32 in the 3^{rd} embodiment) having an inner diameter of 2 mm and a depth of 1 mm was formed.

### (Formation of TiO₂ film and SiO₂ film)

In Example 6, a TiO₂ film and an SiO₂ film were employed as the dielectric film to form the TiO₂ film and the SiO₂ film via sputtering. Specifically, a TiO₂ film having a thickness of 15 nm was first formed on the inner surface of the opening portion formed in the microchip which was subjected to an attachment process, employing a sputtering apparatus (RAS-1100C, manufactured by Shincron Co., Ltd), and an SiO₂ film having a thickness of 120 nm was formed on the TiO₂ film. A TiO₂ film and an SiO₂ film were able to be evenly formed on the inner surface (the inward side surface and the bottom surface) of an opening portion having an inner diameter of 2 mm and a depth of 1 mm, employing a sputtering apparatus. A TiO₂ film and a SiO₂ film formed on the inward side surface of the opening portion had a total thickness t₁ of 100 nm, and another TiO₂ film and another SiO₂ film formed on the bottom surface had a total thickness t₂ of 135 nm. In this case, a ratio t₁/t₂ is 0.74 (= 100/135), resulting in at least 1/2.

Further, a TiO₂ film and an SiO₂ film may be formed by masking the surface of a microchip so as to form the TiO₂ film and the SiO₂ film only on the inner surface of an opening portion, and may also be formed via no masking of the surface. The effect of exhibiting excellent abrasion-resistance with respect to the microchip surface is produced by forming the TiO₂ film and the SiO₂ film on the surface of a microchip. Further, masking cost can be reduced. In the case of Example 6, a TiO₂ film and an SiO₂ film were formed with no masking on the side of the flow path side microchip substrate on which an opening portion (through-hole) is formed.

### (Evaluation)

When a microchip of Example 6 was connected to a syringe pump to feed water at a pressure of 0.13 MPa, no liquid leaked from the fine flow path and the vicinity of the opening portion, resulting in sufficient sealing performance. The following means after attaching the flow path side microchip substrate and the cover side microchip substrate to each other, and similarly to Comparative example, the spacing between the flow path side microchip substrate and the cover side microchip substrate was produced in the vicinity of the opening portion before forming a TiO₂ film and an SiO₂ film in the opening portion, but it would appear that the spacing was possible to be filled in by forming the TiO₂ film and the SiO₂ film on the inner surface of the opening portion.

Further, when the cross-section of the microchip in Example 6 was prepared with a microtome, and the cross-section was observed with an electron microscope, it was confirmed that the TiO₂ film and the SiO₂ film were evenly formed with no rupture on the inner surface of an opening portion. By this, it was confirmed that the TiO₂ film and the SiO₂ film served as the function to prevent the liquid leakage in the vicinity of the opening portion.

Further, since the inner surface of the opening portion was covered by a hydrophilic SiO₂ film, it was confirmed that water, a reagent or the like was possible to be smoothly introduced into the opening portion and the fine flow path via capillarity action with no pressure-feeding of water, the reagent or the like.

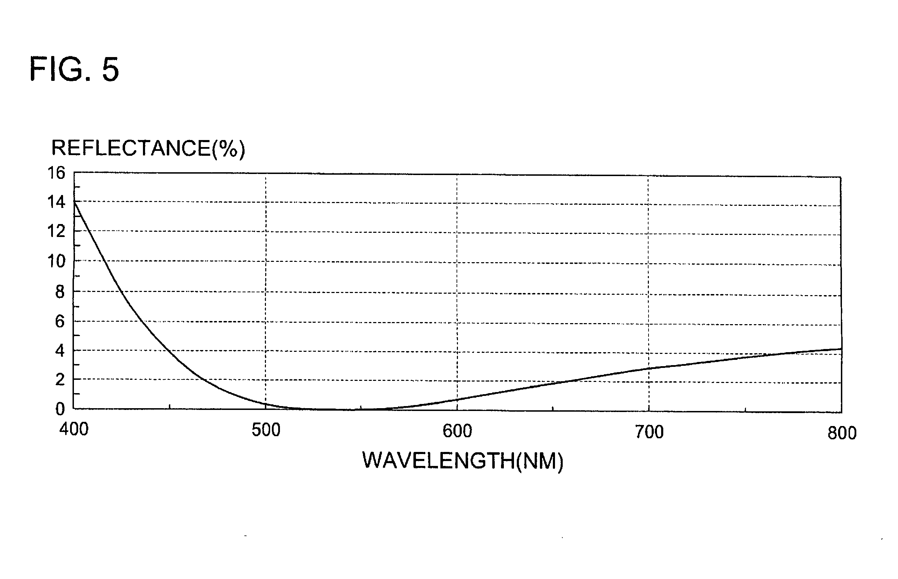

Further, reflectance of the microchip surface (the surface of the flow path side microchip) was measured. Measured results thereof are shown in Fig. 5. Fig. 5 is a graph showing reflectance of a microchip in Example 6. The horizontal axis represents wavelength, and the vertical axis represents reflectance. It was understood that the microchip surface served as the function of an antireflection film in the range of 450 - 750 nm, as shown in the graph of Fig. 5. During analysis, light use efficiency can be raised by detecting a specimen by delivering light from the side of the surface on which a TiO₂ film and an SiO₂ film are formed, employing this microchip. It was confirmed that not only liquid leakage was prevented, but also the effect of scratch-resistance together with antireflection was produced by adjusting film thickness of each of dielectric films (a TiO₂ film and an SiO₂ film) or laminating layers made of each material having different reflectance, as described above.

As stated above, it becomes possible to prevent liquid leakage in the vicinity of an opening portion by forming a dielectric film in the opening portion of a microchip, as described in Examples 1 - 6. In addition, material constituting a microchip substrate, a method of forming an SiO₂ film as well as a TiO₂ film or the like is just one example, and the present invention is not limited thereto.

## Claims

1. A microchip comprising a flow path groove (11, 21, 31) formed on a surface of at least one of two substrates (10, 14, 20, 22, 30, 35) each made of a resin, and a through-hole (12, 23, 32) communicated with the flow path groove (11, 21, 31) to form an opening portion to the outside in at least one of the two substrates (10, 14, 20, 22, 30, 35),,
wherein the two substrates (10, 14, 20, 22, 30, 35) are attached to each other so as to place the surface on which the flow path groove (11, 21, 31) is formed on an inward side, and
wherein at least one dielectric film (13, 24, 33, 34) is formed on an inner surface of the opening portion (12, 23, 32), the inner surface comprising an inward side surface and a bottom surface;
wherein
said dielectric film (13, 24, 33, 34) is continuously formed with no rupture or fracture from the inward side surface of the opening portion (12, 23, 32) to the bottom surface.

2. The microchip of Claim 1,
**characterized in that** the dielectric film (13, 24, 33, 34) is an SiO₂ film or a TiO₂ film.

3. The microchip of Claim 1,
**characterized in that** the dielectric film (13, 24, 33, 34) comprises layered films each made of a different material.

4. The microchip of Claim 3,
**characterized in that** the dielectric film comprises a TiO₂ film, and a SiO₂ film layered on the TiO₂ film.

5. The microchip of any one of Claims 1 - 4,
**characterized in that** a ratio (t₁/t₂) of thickness t₁ of a dielectric film (13, 24, 33, 34) formed on the inward side surface of the opening portion (12, 23, 32) to thickness t₂ of another dielectric film (13, 24, 33, 34) formed on the bottom surface of the opening portion (12, 23, 32), via attachment of the two substrates (10, 14, 20, 22, 30, 35) to each other, is at least 1/10.

6. The microchip of any one of Claims 1 - 4,
**characterized in that** a ratio (t₁/t₂) of thickness t₁ of a dielectric film (13, 24, 33, 34) formed on the inward side surface of the opening portion (12, 23, 32) to thickness t₂ of another dielectric film (13, 24, 33, 34) formed on the bottom surface of the opening portion (12, 23, 32), via attachment of the two substrates (10, 14, 20, 22, 30, 35) to each other, is at least 1/3.

7. The microchip of any one of Claims 1 - 4,
**characterized in that** a ratio (t₁/t₂) of thickness t₁ of a dielectric film (13, 24, 33, 34) formed on the inward side surface of the opening portion (12, 23, 32) to thickness t₂ of another dielectric film (13, 24, 33, 34) formed on the bottom surface of the opening portion (12, 23, 32), via attachment of the two substrates (10, 14, 20, 22, 30, 35) to each other, is at least 1/2.

8. The microchip of any one of Claims 1 - 7, **characterized by** comprising the dielectric film (13, 24, 33, 34) formed on the inner surface of the opening portion (12, 23, 32) and on another surface of the flow path groove (11, 21, 31).

9. A method of manufacturing a microchip comprising the steps of:
forming a flow path groove on a surface of at least one of two substrates (10, 14, 20, 22, 30, 35) each made of a resin;
forming a through-hole (12, 23, 32) communicated with the flow path groove (11, 21, 31) in at least one of the two substrates (10, 14, 20, 22, 30, 35) to form an opening portion (12, 23, 32) into the outside; and
attaching the two substrates (10, 14, 20, 22, 30, 35) to each other so as to place the surface on which the flow path groove (11, 21, 31) is formed on an inward side,
forming at least one continuous dielectric film (13, 24, 33, 34) on the inner surface of the opening portion, after attaching the two substrates (10, 14, 20, 22, 30, 35) to each other.

10. The method of Claim 9, further comprising the step of:
forming the dielectric film (13, 24, 33, 34) in the opening portion via plasma CVD, sputtering, coating or microplasma jet.

## Patentansprüche

1. Mikrochip mit einer Strömungspfadrille (11, 21, 31), die an einer Fläche von zumindest einem von zwei Substraten (10, 14, 20, 22, 30, 35) ausgebildet ist, wobei jedes aus einem Harz hergestellt ist, und einem Durchgangsloch (12, 23, 32), das mit der Strömungspfadrille (11, 21, 31) kommuniziert, in zumindest einem der beiden Substrate (10, 14, 20, 22, 30, 35), um einen Öffnungsabschnitt zu der Außenseite auszubilden,
wobei die beiden Substrate (10, 14, 20, 22, 30, 35) aneinander angebracht sind, so dass die Fläche, an welcher die Strömungspfadrille (11, 21, 31) ausgebildet ist, an einer Innenseite angeordnet ist, und
wobei zumindest ein dielektrischer Film (13, 24, 33, 34) an einer Innenfläche des Öffnungsabschnitts (12, 23, 32) ausgebildet ist, wobei die Innenfläche eine Innenseitenfläche und eine Bodenfläche aufweist,
wobei
der dielektrische Film (13, 24, 33, 34) kontinuierlich und ohne eine Ruptur oder eine Fraktur von der Innenseitenfläche des Öffnungsabschnitts (12, 23, 32) zu der Bodenfläche ausgebildet ist.

2. Mikrochip nach Anspruch 1,
wobei der dielektrische Film (13, 24, 33, 34) ein SiO₂-Film oder ein TiO₂-Film ist.

3. Mikrochip nach Anspruch 1,
wobei der dielektrische Film (13, 24, 33, 34) geschichtete Filme aufweist, die jeweils aus einem unterschiedlichen Material hergestellt sind.

4. Mikrochip nach Anspruch 3,
wobei der dielektrische Film einen TiO₂-Film und einen auf dem TiO₂-Film geschichteten SiO₂-Film aufweist.

5. Mikrochip nach einem der Ansprüche 1 bis 4,
wobei ein Verhältnis (t₁/t₂) der Dicke t₁ eines dielektrischen Films (13, 24, 33, 34), der an der Innenseitenfläche des Öffnungsabschnitts (12, 23, 32) ausgebildet ist, zu der Dicke t₂ eines anderen dielektrischen Films (13, 24, 33, 34), der an der Bodenfläche des Öffnungsabschnitts (12, 23, 32) ausgebildet ist, über eine Anbringung der beiden Substrate (10, 14, 20, 22, 30, 35) aneinander, zumindest 1/10 beträgt.

6. Mikrochip nach einem der Ansprüche 1 bis 4,
wobei ein Verhältnis (t₁/t₂) der Dicke t₁ eines dielektrischen Films (13, 24, 33, 34), der an der Innenseitenfläche des Öffnungsabschnitts (12, 23, 32) ausgebildet ist, zu der Dicke t₂ eines anderen dielektrischen Films (13, 24, 33, 34), der an der Bodenfläche des Öffnungsabschnitts (12, 23, 32) ausgebildet ist, über eine Anbringung der beiden Substrate (10, 14, 20, 22, 30, 35) aneinander, zumindest 1/3 beträgt.

7. Mikrochip nach einem der Ansprüche 1 bis 4,
wobei ein Verhältnis (t₁/t₂) der Dicke t₁ eines dielektrischen Films (13, 24, 33, 34), der an der Innenseitenfläche des Öffnungsabschnitts (12, 23, 32) ausgebildet ist, zu der Dicke t₂ eines anderen dielektrischen Films (13, 24, 33, 34), der an der Bodenfläche des Öffnungsabschnitts (12, 23, 32) ausgebildet ist, über eine Anbringung der beiden Substrate (10, 14, 20, 22, 30, 35) aneinander, zumindest 1/2 beträgt.

8. Mikrochip nach einem der Ansprüche 1 bis 7, ferner mit dem dielektrischen Film (13, 24, 33, 34), der an der Innenfläche des Öffnungsabschnitts (12, 23, 32) und an einer anderen Fläche der Strömungspfadrille (11, 21, 31) ausgebildet ist.

9. Verfahren zum Herstellen eines Mikrochips mit den Schritten:
Ausbilden einer Strömungspfadrille an einer Fläche von zumindest einem von zwei Substraten (10, 14, 20, 22, 30, 35), wobei jedes aus einem Harz hergestellt ist,
Ausbilden eines Durchgangslochs (12, 23, 32), das mit der Strömungspfadrille (11, 21, 31) kommuniziert, in zumindest einem der beiden Substrate (10, 14, 20, 22, 30, 35), um einen Öffnungsabschnitt (12, 23, 32) zu der Außenseite auszubilden, und
Anbringen der beiden Substrate (10, 14, 20, 22, 30, 35) aneinander, so dass die Fläche, an welcher die Strömungspfadrille (11, 21, 31) ausgebildet ist, an einer Innenseite angeordnet ist,
Ausbilden von zumindest einem kontinuierlichen Film (13, 24, 33, 34) an der Innenfläche des Öffnungsabschnitts, nach dem Anbringen der beiden Substrate (10, 14, 20, 22, 30, 35) aneinander.

10. Verfahren nach Anspruch 9, ferner mit dem Schritt:
Ausbilden des dielektrischen Films (13, 24, 33, 34) in dem Öffnungsabschnitt über ein Plasma-CVD, Sputtern, Beschichten oder Ausstoßen von Mikroplasma.

## Revendications

1. Micropuce comprenant une rainure de trajet d'écoulement (11, 21, 31) formée sur une surface d'au moins un de deux substrats (10, 14, 20, 22, 30, 35), chacun constitué d'une résine, et un trou traversant (12, 23, 32) en communication avec la rainure de trajet d'écoulement (11, 21, 31) pour former une partie d'ouverture vers l'extérieur dans au moins l'un des deux substrats (10, 14, 20, 22, 30, 35),
dans laquelle les deux substrats (10, 14, 20, 22, 30, 35) sont attachés l'un à l'autre de sorte à placer la surface sur laquelle est formée la rainure de trajet d'écoulement (11, 21, 31) sur un côté intérieur, et
dans laquelle au moins un film diélectrique (13, 24, 33, 34) est formé sur une surface interne de la partie d'ouverture (12, 23, 32), la surface interne comprenant une surface de côté intérieur et une surface inférieure ;
dans laquelle
ledit film diélectrique (13, 24, 33, 34) est formé en continu sans rupture ni fracture de la surface de côté intérieur de la partie d'ouverture (12, 23, 32) à la surface inférieure.

2. Micropuce selon la revendication 1, **caractérisée en ce que** le film diélectrique (13, 24, 33, 34) est un film de SiO₂ ou un film de TiO₂.

3. Micropuce selon la revendication 1,
**caractérisée en ce que** le film diélectrique (13, 24, 33, 34) comprend des films superposés, chacun constitué d'un matériau différent.

4. Micropuce selon la revendication 3,
**caractérisée en ce que** le film diélectrique comprend un film de TiO₂ et un film de SiO₂ superposé au film de TiO₂.

5. Micropuce selon l'une quelconque des revendications 1 à 4,
**caractérisée en ce qu'**un rapport (t₁/t₂) de l'épaisseur t₁ d'un film diélectrique (13, 24, 33, 34) formé sur la surface de côté intérieur de la partie d'ouverture (12, 23, 32) sur l'épaisseur t₂ d'un autre film diélectrique (13, 24, 33, 34) formé sur la surface inférieure de la partie d'ouverture (12, 23, 32), via la fixation des deux substrats (10, 14, 20, 22, 30, 35) l'un à l'autre, est d'au moins 1/10.

6. Micropuce selon l'une quelconque des revendications 1 à 4,
**caractérisée en ce qu'**un rapport (t₁/t₂) de l'épaisseur t₁ d'un film diélectrique (13, 24, 33, 34) formé sur la surface de côté intérieur de la partie d'ouverture (12, 23, 32) sur l'épaisseur t₂ d'un autre film diélectrique (13, 24, 33, 34) formé sur la surface inférieure de la partie d'ouverture (12, 23, 32), via la fixation des deux substrats (10, 14, 20, 22, 30, 35) l'un à l'autre, est d'au moins 1/3.

7. Micropuce selon l'une quelconque des revendications 1 à 4,
**caractérisée en ce qu'**un rapport (t₁/t₂) de l'épaisseur t₁ d'un film diélectrique (13, 24, 33, 34) formé sur la surface de côté intérieur de la partie d'ouverture (12, 23, 32) sur l'épaisseur t₂ d'un autre film diélectrique (13, 24, 33, 34) formé sur la surface inférieure de la partie d'ouverture (12, 23, 32), via la fixation des deux substrats (10, 14, 20, 22, 30, 35) l'un à l'autre, est au moins de 1/2.

8. Micropuce selon l'une quelconque des revendications 1 à 7, **caractérisée en ce qu'**elle comprend le film diélectrique (13, 24, 33, 34) formé sur la surface interne de la partie d'ouverture (12, 23, 32) et sur une autre surface de la rainure de trajet d'écoulement (11, 21, 31).

9. Procédé de fabrication d'une micropuce comprenant les étapes suivantes :
la formation d'une rainure de trajet d'écoulement sur une surface d'au moins l'un de deux substrats (10, 14, 20, 22, 30, 35), chacun constitué d'une résine ;
la formation d'un trou traversant (12, 23, 32) en communication avec la rainure de trajet d'écoulement (11, 21, 31) dans au moins l'un des deux substrats (10, 14, 20, 22, 30, 35) pour former une partie d'ouverture (12, 23, 32) vers l'extérieur ; et
la fixation des deux substrats (10, 14, 20, 22, 30, 35) l'un à l'autre de sorte à placer la surface sur laquelle est formée la rainure de trajet d'écoulement (11, 21, 31) sur un côté intérieur,
la formation d'au moins un film diélectrique continu (13, 24, 33, 34) sur la surface interne de la partie d'ouverture, après fixation des deux substrats (10, 14, 20, 22, 30, 35) l'un à l'autre.

10. Procédé selon la revendication 9, comprenant en outre l'étape suivante :
la formation du film diélectrique (13, 24, 33, 34) dans la partie d'ouverture via CVD assisté par plasma, pulvérisation cathodique, revêtement ou jet de microplasma.
